# EUROPÄISCHE PATENTANMELDUNG

(11) **EP 3 357 879 A1**
(43) Veröffentlichungstag der Anmeldung: **08.08.2018**
(21) Anmeldenummer: 17154977.7
(22) Anmeldetag: 07.02.2017
(51) Int. Cl.: C03C 15/00, C03C 23/00

(54) **GASVERTEILELEMENT FÜR DEN EINSATZ IN DER HALBLEITERFERTIGUNG SOWIE VERFAHREN ZUR HERSTELLUNG EINES GASVERTEILELEMENTS**

(71) Anmelder: Heraeus Quarzglas GmbH & Co. KG, 63450 Hanau (DE)
(72) Erfinder: Hofmann, Achim, 60599 Frankfurt (DE)
(74) Vertreter: Staudt, Armin Walter

(57) **Zusammenfassung**

Bei bekannten Verfahren zur Herstellung eines Gasverteilelements für den Einsatz in der Halbleiterfertigung werden ein Basiskörper aus Quarzglas mit mindestens einer Wandung bereitgestellt, eine Soll-Position und eine Soll-Innenkontur für jede einer Vielzahl von Gasdüsen definiert, und an der Soll-Position wird eine durchgehende Öffnung in der Wandung mit der jeweiligen Soll-Innenkontur der Gasdüse erzeugt. Um hiervon ausgehend das Gasverteilelement dahingehend zu verbessern, dass es die Verteilung des Prozessgases entsprechend einem gewünschten Strömungsmuster homogen und reproduzierbar gewährleistet, wird erfindungsgemäß vorgeschlagen, dass das Erzeugen der Öffnung folgende Verfahrensschritte umfasst: (a) Verändern mindestens eines Teils des Quarzglases im Bereich der zu erzeugenden Öffnung durch Bestrahlung mit ultrakurzen Laserpulsen im Femtosekundenbereich, und (b) Entfernen des veränderten Quarzglases durch Ätzen mittels Säure oder Lauge unter Bildung der Öffnung.

## Beschreibung

Die Erfindung betrifft ein Verfahren zur Herstellung eines eine Vielzahl von Gasdüsen aufweisenden Gasverteilelements für den Einsatz in der Halbleiterfertigung, durch Bereitstellen eines Basiskörpers aus Quarzglas mit mindestens einer Wandung, Definieren einer Soll-Position und einer Soll-Innenkontur für jede der Gasdüsen, und Erzeugen einer durchgehenden Öffnung in der Wandung an der Soll-Position und mit der Soll-Innenkontur der jeweiligen Gasdüse.

Außerdem geht es bei der Erfindung um ein Gasverteilelement für den Einsatz in der Halbleiterfertigung, das einen Basiskörper mit einer beidseitig von Wandungsoberflächen begrenzten Wandung aufweist, durch die sich eine Vielzahl von Durchgangsbohrungen erstreckt, die jeweils mit den Wandungsoberflächen umlaufende Bohrungsränder bilden

In der Halbleitertechnologie werden Halbleitersubstrate (Wafer) in chemischen Reaktoren prozessiert, wobei Diffusions-, Abscheide-, Dotier-und Ätzprozesse durchgeführt werden. Je nach Anzahl der zeitgleich im Reaktor behandelten Wafer wird unterschieden zwischen Einzelwaferprozessen (Single-Wafer-Prozesse) und Multiwaferprozessen (Batch-Prozesse), bei denen mehrere in einer Horde übereinander gestapelte Wafer gleichzeitig verarbeitet werden.

Die Prozessierung jedes Wafers erfordert eine Reihe von Verfahrensschritten, bei denen Prozessgase auf seine Oberfläche einwirken. Beim Batch-Prozess werden die Gase üblicherweise durch einen oder mehrere rohrförmige Gasinjektoren zugeführt, die entlang der Wafer-Horde verlaufen und die in Höhe der Wafer mindestens eine Gasauslassöffnung durch die Rohrwand aufweisen. Beim Single-Wafer-Prozess wird in der Regel eine parallel zur bearbeitenden Wafer-Oberfläche angeordnete Gasverteilerplatte (showerhead) mit einer Vielzahl von auf die Wafer-Oberfläche gerichteten Gasauslassöffnungen eingesetzt.

### Stand der Technik

Ein Beispiel für einen rohrförmigen Gasinjektor für die Batch-Prozessierung ist in der US 9,017,763 B2 beschrieben. Dieser weist eine Vielzahl von Lochstrukturen auf, die jeweils dem Zwischenraum benachbarter Wafer des Waferstapels zugeordnet sind. Das Zentrum jeder Lochstruktur ist dabei über der Waferoberfläche in einer Höhe angeordnet, die oberhalb des halben Wafer-Wafer-Abstands liegt. Die vorgegebene Soll-Innenkontur der Gasdüsen ist zylinderförmig.

Aus der EP 0 844 314 B1 ist eine im Querschnitt kreisförmige Gasverteilerplatte bekannt, die mit einer Vielzahl von Gasdüsen perforiert ist, die entlang konzentrischer Kreise verlaufen. Durch mechanische Abtrennungen sind die Gasdüsen in mehrere koaxiale Gasverteilungszonen aufgeteilt. Jede der Gasverteilungszonen ist mit einer eigenen Gasversorgungsleitung und einem Massenstromregler ausgestattet, so dass die ausströmenden Gasmengen und die Strömungsgeschwindigkeiten unabhängig voneinander einstellbar sind. Auch hier ist die vorgegebene -Innenkontur der Gasdüsen zylinderförmig.

Hier und im Folgenden werden derartige Gasinjektoren beziehungsweise Gasverteilerplatten auch unter dem Begriff "Gasverteilelemente" zusammengefasst und die "Gasauslassöffnungen kurz als "Gasdüsen" bezeichnet.

### Technische Aufgabe

Grundsätzlich stellt sich das Problem, die Behandlung der Wafer in jedem Verfahrensschritt so gleichmäßig und reproduzierbar wie möglich zu gestalten. Die ablaufenden Prozesse sind maßgeblich durch Temperatur und Massetransportvorgänge bestimmt, so dass Temperatur-Homogenität und Verteilung der Prozessgase Gegenstand ständiger Weiterentwicklung sind.

Ein besonderes Augenmerk liegt dabei auf den Gasdüsen, denn diese stellen bei den jeweiligen Gasverteilelementen ein enges und in der Regel das letzte Gestaltungselement vor dem Wafer dar. Daher haben deren Position, Orientierung, Durchmesser und Oberflächenqualität großen Einfluss auf Menge und Strömungsrichtung der Prozessgase.

Die Bohrungen für die Gasdüsen werden üblicherweise mechanisch erzeugt oder thermisch durch Laserbohren mit CO₂-Lasern, wobei das Glasmaterial quasi thermisch verdampft wird. Daraus ergeben sich Limitierungen bezüglich Genauigkeit, Reproduzierbarkeit und Komplexität der Gasdüsen.

Die Erfindung zielt darauf ab, die bekannten Gasverteilelemente dahingehend zu verbessern, dass sie die Verteilung des Prozessgases entsprechend einem gewünschten Strömungsmuster homogen und reproduzierbar gewährleisten.

### Allgemeine Beschreibung der Erfindung

Hinsichtlich des Verfahrens zur Herstellung des Gasverteilelements wird diese Aufgabe ausgehend von einem Verfahren der eingangs genannten Gattung erfindungsgemäß dadurch gelöst, dass das Erzeugen der Öffnung folgende Verfahrensschritte umfasst:
(a) Verändern mindestens eines Teils des Quarzglases im Bereich der zu erzeugenden Öffnung durch Bestrahlung mit ultrakurzen Laserpulsen im Femtosekundenbereich,
(b) Entfernen des veränderten Quarzglases durch Ätzen mittels Ätzlösung unter Bildung der Öffnung.

Beim erfindungsgemäßen Verfahren werden die Öffnungen in der Wandung des Gasverteilelements aller Gasdüsen oder mindestens derjenigen Gasdüsen, bei denen mit hohen Qualitäts-Anforderungen anhand eines mehrstufigen Verfahrens erzeugt, das einen Schädigungsschritt durch Laserbestrahlung und einen Ätzschritt umfasst. Diese Verfahrensweise wird im Folgenden auch als "Laser-Ätz-Verfahren" bezeichnet.

Es ist bekannt, dass die Quarzglas-Struktur durch ultrakurzpulsige Laserbestrahlung vorgeschädigt wird. Anschließend kann das so veränderte, vorgeschädigte Quarzglas selektiv mittels einer Ätzlösung geätzt und abgetragen werden. Bei der Ätzlösung handelt es sich typischerweise um eine Säure oder um eine Lauge.

Der Laserstrahl mit ultrakurzen Pulsen im Femtosekundenbereich (10⁻¹⁵s) wird mittels eines Femtosekundenlasers erzeugt und auf den zu verändernden, vorzuschädigenden Volumenbereich fokussiert. Um einen größeren Volumenbereich vorzuschädigen, wird der Laserstrahl-Fokus rasterweise verlagert, was im Folgenden auch als "Abrastern" bezeichnet wird.

Mit dieser Methode lassen sich computergesteuert präzise Strukturen in Quarzglas mit der Auflösung von wenigen Mikrometern "ausschneiden". Im Vergleich zum mechanischen Ausbohren der Öffnungen ergibt sich eine geringere Schädigung sowohl der Innenwandung der Öffnung als auch der ursprünglichen Oberflächen der perforierten Wandung, und auch eine höhere Genauigkeit und Reproduzierbarkeit sowohl bei der Einhaltung der Soll-Position als auch der Soll-Innenkontur der Öffnung.

Beim Ausbohren der Öffnungen mittels Laserstrahl kommt es zu einer thermischen Belastung und Veränderung des die Bohrung umgebenden Quarzglases, was zu Spannungen und Verformungen führen kann und die Genauigkeit und Reproduzierbarkeit der Gasdüsen beeinträchtigt. Im Vergleich dazu bewirkt das erfindungsgemäße Laser-Ätz-Verfahren eine geringe thermische Belastung des die Bohrung umgebenden Quarzglases. Es besteht auch die Gefahr, dass sich das mittels Laserstrahl ausgetriebene Quarzglas um den Bohrungsrand ablagert und dabei einen umlaufenden Wulst bildet, der die Gasführung beeinflusst. Zur Beseitigen des umlaufenden Wulstes ist eine nachträgliche mechanische Glättung der Oberfläche der perforierten Wandung erforderlich, was aber in der Praxis häufig nicht möglich oder unerwünscht ist, wie beispielsweise bei rohrförmigen Basiskörperm und bei filigranen Wandungen.

Das anhand des Laser-Ätz-Verfahrens erzeugte Gasverteilelement verfügt über Gasdüsen, die sich durch Genauigkeit und Reproduzierbarkeit auszeichnen, so dass die Verteilung der Prozessgase entsprechend einem gewünschten Strömungsmuster reproduzierbar gewährleistet werden kann.

Die vorab definierte Soll-Innenkontur der Gasdüse wird von einem Volumenbereich ausgefüllt. Dieser kann vollständig oder teilweise abgerastert und vorgeschädigt werden. Das Vorschädigen von nur einem Teil dieses Volumenbereichs erfolgt bei einer bevorzugten Verfahrensweise, bei der die Öffnung eine umlaufende Innenwandung aufweist, indem eine an die Innenwandung angrenzende Schicht des Quarzglases verändert wird, die einen nicht veränderten Kernbereich umgibt.

Hierbei bildet der vorgeschädigte Volumenbereich eine geschlossene, umlaufende Mantelschicht um den Kernbereich. Diese Mantelschicht wird beim anschließenden Ätzvorgang selektiv entfernt, so dass der Kernbereich seinen Kontakt mit der Innenwandung der Öffnung verliert und - obwohl nicht vorgeschädigt - aus der Öffnung entfernt wird. Bei dieser Verfahrensweise genügt im einfachsten Fall das Abrastern der Außenkontur der zu erzeugenden Öffnung; sie verkürzt die Bearbeitungsdauer, spart Energie und hat insbesondere Kostenvorteile beim Erzeugen großvolumiger Öffnungen.

Bei den bisher bekannten Verfahrensweisen zur Herstellung der Gasdüsen-Öffnungen durch mechanisches oder thermisches Bohren ist es schwierig, von der Zylinderform abweichende Öffnungen definiert zu erzeugen. Hier schafft eine bevorzugte Verfahrensvariante des erfindungsgemäßen Verfahrens Abhilfe, bei der die vorgegebene Soll-Innenkontur der Gasdüse mit einer sich in einer Gasflussrichtung erweiternden oder einer sich in der Gasflussrichtung verengenden Öffnungsweite definiert und erzeugt wird.

Im Vergleich zu den bisher üblichen, zylinderförmigen Öffnungen ist die sich in Gasflussrichtung verengende Öffnung zur Fokussierung und/oder Beschleunigung eines Gasstroms geeignet und erfüllt insoweit eine typische Düsenfunktion. Umgekehrt wirkt die sich in Gasflussrichtung erweiternde Öffnung als Gas-Diffusor und verlangsamt die Ausströmungsgeschwindigkeit. Die genannten Wirkungen treten auch dann ein, wenn der Bereich der sich verengenden beziehungsweise der sich erweiternden Öffnung nicht über die gesamte Öffnungslänge, sondern nur über eine Teillänge der Öffnung erstreckt.

Beim Laser-Ätz-Verfahren wird die vorab definierte Soll-Innenkontur der Gasdüse beispielsweise durch numerische Simulation optimiert und als Programmcode hinterlegt. Die optimierten Düsendesigns können programmgesteuert durch die rasterweise Verlagerung des Laserstrahl-Fokus entlang der Innenkontur in die Fertigung umgesetzt werden. Diese Verfahrensweise begrenzt die Komplexität der Soll-Innenkontur nicht. So ist beispielsweise bei einer einfachen und bevorzugten Verfahrensvariante vorgesehen, dass der Querschnitt der Öffnung - in Glasflussrichtung gesehen - rund ist, und dass mindestens für einen Teil der Gasdüsen die Innenkontur als Innenkonus definiert und erzeugt wird.

Bei einer alternativen und besonders vorteilhaften Verfahrensvariante ist vorgesehen, für mindestens einen Teil der Gasdüsen eine schlitzförmige Innenkontur definiert und erzeugt wird.

Der Querschnitt der Öffnung - in Glasflussrichtung gesehen - ist länglich, beispielsweise oval oder rechteckig. Diese Ausführungsform der Gasdüse mit einer schlitzförmigen, länglichen Düsenöffnung wird im Folgenden auch als "Flachdüse" bezeichnet. Flachdüsen sind geeignet zur Formung einer flachen, fächerförmigen Gasströmung und eignen sich insbesondere für rohrförmige Gasverteilelementen im Batchverfahren. Die lange Seite der Flachdüsen-Öffnung verläuft dabei im Wesentlichen parallel zur Oberfläche der zu behandelnden Wafer. Die flache, fächerförmige Gasströmung ist dabei in den Zwischenraum benachbarter Wafer gerichtet.

Die Öffnung weist den länglichen Querschnitt über ihre gesamte Länge oder über einen Teil ihrer Länge auf. Zur Formung der flachen, fächerförmigen Gasströmung genügt es, wenn die Öffnung im Bereich der Düsenöffnung diese Geometrie hat. Die Fokussierung des Gasstroms zwischen die Wafer des Waferstapels kann noch dadurch verbessert werden, dass sich die schmale Öffnungsweite der Flachdüse in Glasflussrichtung verjüngt.

Bei einer anderen bevorzugten Verfahrensvariante wird aber eine Flachdüse erzeugt, bei der sich die breite Öffnungsweite in Glasflussrichtung erweitert. Diese Flachdüse dient als Gas-Diffusor, mit der Wirkung, dass sich die Ausströmungsgeschwindigkeit verlangsamt und so ein Beitrag zu einer möglichst gleichmäßigen Verteilung des Behandlungsgases über der Wafer-Oberfläche erreicht wird. Auch bei dieser Ausführungsform tritt diese Wirkung auch dann ein, wenn der Bereich der erweiternden Flachdüsen-Öffnung sich nicht über die gesamte Öffnungslänge, sondern nur über eine Teillänge der Öffnung erstreckt.

Diese Ausführungsform der Flachdüse, bei der sich die breite Öffnungsweite in Glasflussrichtung erweitert und die so eine fächerartige Ausbreitung des Gasstroms im Wafer-Zwischenraum in horizontaler Richtung bewirkt, ist vorzugsweise kombiniert mit einer schmalen Öffnungsweite, die sich in Glasflussrichtung verjüngt, und auf diese Weise eine Fokussierung des Gasstroms in vertikaler Richtung in den Wafer-Zwischenraum bewirkt.

Das erfindungsgemäße Verfahren erlaubt nicht nur eine flexible Gestaltung in Bezug auf die Innenkontur der Gasdüsen, sondern auch in Bezug auf deren Orientierung in der Wandung des Basiskörpers. So zeichnet sich eine bevorzugte Verfahrensweise dadurch aus, dass die Wandung an der Soll-Position eine Oberfläche mit einer Flächennormalen aufweist, und dass eine durchgehende Bohrung mit einer Mittelachse erzeugt wird, die zur Flächennormalen geneigt ist.

Die Richtung einer aus der Düse austretenden Gasströmung wird im Wesentlichen durch die Richtung der Bohrungsmittelachse im Bereich des Gasaustritts bestimmt. Eine in diesem Bereich zur Flächennormalen in einem Winkel zwischen 10 und 80 Grad geneigte oder dazu schiefwinkelig verlaufende Bohrungsmittelachse ermöglicht es, eine gerichtete Gasströmung mit einer von der Flächennormalen abweichenden Strömungsrichtung zu erzeugen.

Es hat sich außerdem als vorteilhaft erweisen, wenn für eine erste Gruppe von Gasdüsen eine erste Innenkontur, und für eine zweite Gruppe von Gasdüsen eine zweite Innenkontur definiert wird, wobei sich die erste Innenkontur von der zweiten Innenkontur unterscheidet.

Da Geometrie und Position der Gasdüsen vorab definiert und als Programmcode hinterlegt sind, ergibt sich keine besondere Schwierigkeit bei der Fertigung nicht identischer Gasdüsen, oder anders gesagt, bei der Fertigung von Gasdüsen, bei denen die Geometrie von ihrer Position abhängt. Diese Verfahrensvariante ist besonders vorteilhaft für die Fertigung eines plattenförmigen Gasverteilelements für die Single-Wafer-Prozessierung einsetzbar, bei dem mehrere Reihen von Gasdüsen vorgesehen sind, die konzentrische Kreise um den Plattenmittelpunkt bilden, und bei denen sich Geometrie und/oder Orientierung der Gasdüsen in einer Reihe von der (Geometrie und/oder Orientierung) einer benachbarten Reihe unterscheiden. Die sich unterscheidende geometrische Parameter ist beispielsweise die Öffnungsweite der jeweiligen Gasdüsen.

Vorzugsweise wird ein Basiskörper eingesetzt, der aus Quarzglas besteht, das einen Hydroxylgruppengehalt im Bereich von 10 bis 300 Gew.-ppm aufweist.

Es hat sich gezeigt, dass ein vergleichsweise geringer Hydroxylgruppengehalt im genannten Bereich das Vorschädigen des Quarzglases durch Bestrahlung mittels Femtosekundenlaser vereinfacht. Dies kann darauf zurückgeführt werden, dass Hydroxylgruppen die Bildung von strahlungsgenerierten Glasdefekten verhindern oder erschweren können oder dass sie ein Ausheilen derartiger Glasdefekte begünstigen können.

Die Innenwandung der mittels Laser-Ätz-Verfahren erzeugten Öffnung zeigt eine Ätzstruktur, die in der Regel eine gewisse durch den Strukturierungs- und Ätzprozess hervorgerufene Oberflächenrauigkeit hat. Für anspruchsvolle Anwendungen des Gasverteilelements, bei denen es auf einen möglichst turbulenzfrei aus der Gasdüse austretenden Gasstrom ankommt, hat sich eine Verfahrensweise bewährt, bei der die Innenwandung der Öffnung auf eine Temperatur oberhalb von 1200 °C erhitzt und dadurch mindestens teilweise lokal aufgeschmolzen wird.

Das lokale Aufschmelzen bewirkt eine der Feuerpolitur vergleichbare Glättung der Innenbohrung. Zur Erzeugung der Glättung wird zum lokalen Aufschmelzen der Innenwandung bevorzugt ein Lichtbogen in der Öffnung gezündet.

Der Lichtbogen wird zwischen zwei Elektroden gezündet, von denen mindestens die eine unmittelbar an einer Seite der Öffnung positioniert ist oder sogar in die Öffnung hineinragt. Vorzugsweise sind die Elektroden an den sich gegenüberliegenden Seiten der Öffnung positioniert beziehungsweise sie ragen von beiden Seiten in die Öffnung hinein.

Die Wandung des Basiskörpers kann beim Ätzen gemäß Verfahrensschritt (b) teilweise abgedeckt sein, um dort einen Ätzangriff zu verhindern. Andernfalls wird auch dort eine ätzstrukturierte Oberfläche mit einer gewissen Rauigkeit erhalten. Allerdings hat es sich gezeigt, dass eine glattere Oberfläche im Vergleich zum mechanischen und thermischen Bohren erhalten wird, die kein nachträgliches mechanisches Glätten erfordert. Daher zeichnet sich eine bevorzugte Verfahrensweise dadurch aus, dass das Gasverteilelement nach dem Verfahrensschritt des Entfernens des veränderten Quarzglases ohne nachfolgende mechanische Glättung der Wandung erhalten wird.

Dies gilt insbesondere auch für eine Verfahrensvariante, bei der ein plattenförmiger Basiskörper mit einer Wandung mit planer, polierter Oberseite und planer, polierter Unterseite bereitgestellt wird, so dass das Gasverteilelement nach dem Verfahrensschritt des Entfernens des veränderten Quarzglases ohne nachfolgende mechanische Glättung der Oberseite und der Unterseite erhalten wird.

Beim thermischen Bohren mittels Laserstrahl lagert sich häufig aus der Bohrung ausgetriebenes Quarzglas am Bohrungsrand ab. Diese Wulstbildung und dadurch verursachte Unebenheiten können oder müssen bei einem stabilen plattenförmigen Basiskörper nachträglich durch mechanisches Bearbeiten, wie etwa durch Schleifen beseitigt werden. Dies ist ein aufwändiger Verfahrensschritt mit dem Risiko einer Verunreinigung oder Beschädigung des ansonsten bereits fertiggestellten Gasverteilelements. Das Bedürfnis oder die Notwendigkeit einer nachträglichen Glättung der Wandungs-Oberflächen entfallen beim erfindungsgemäßen Verfahren, da eine derartige Wulstbildung ausgeschlossen ist.

Hinsichtlich des Gasverteilelements für den Einsatz in der Halbleiterfertigung wird die oben angegebene technische Aufgabe ausgehend von einem Gasverteilelement der eingangs genannten Gattung erfindungsgemäß dadurch gelöst, dass die Durchgangsbohrungen Innendurchmesser von weniger als 1 mm und die Bohrungsränder Kantenform haben und von Kantenflächen mit Ätzstruktur gebildet werden.

Bei der Herstellung des Gasverteilerohres liegt ein perforierter plattenförmiger Basiskörper oder rohrförmiger perforierter Basiskörper als Halbzeug vor. Eine mechanische Bearbeitung dieses Halbzeugs zur Beseitigung etwaiger wulstartiger Materialanhäufungen und anderer Unebenheiten, entstanden bei der Herstellung der Durchgangsbohrungen, ist schwierig oder unmöglich; dies gilt insbesondere bei einem rohrförmigen Basiskörper, weshalb ein Gasverteilelement mit rohrförmigem Basiskörper eine bevorzugte Ausführungsform der Erfindung darstellt.

Das erfindungsgemäße Gasverteilelement wird mittels des oben erläuterten Laser-Ätzverfahrens erzeugt. Nach dem Entfernen des vorgeschädigten Quarzglases zeigen die dem Ätzmittel ausgesetzten Oberflächen des Halbzeugs eine Ätzstruktur; es sind aber keine Wüste und Unebenheiten um den Rand der Durchgangsbohrungen vorhanden. Daher zeigen die Bohrungsränder auch ohne nachträgliche Bearbeitung sowohl an der Rohr-Innenwandung als auch an der Rohr-Außenwandung eine definierte Kante, die entweder abgerundet oder winkelig mit einem vorgegebenen Winkel (beispielsweise im Bereich von 30 bis 150 Grad) gebildet ist.

Die kantenförmige Bohrungskante wird jeweils von Kantenflächen mit reproduzierbarer, gleichmäßiger Ätzstruktur gebildet. Störstellen im Bereich des Bohrungsrandes etwa durch Abplatzungen, Verformungen, Materialanhäufungen oder Ablagerungen, die Turbulenzen des Gasstroms verursachen können und damit die Gasdurchflussmenge verändern und sich auch sonst auf die Strömung unvorhersehbar auswirken können, werden vermieden.

Der Innendurchmesser kann von Durchgangsbohrung zu Durchgangsbohrung variieren. Eine Vielzahl der Durchgangsbohrungen hat aber einen vergleichsweise kleinen Innendurchmesser von 1 mm und weniger. Der kleine Innendurchmesser der Gasdüsen ermöglicht ein Gasverteilelement mit vielen kleinen anstelle wenigen großen Gasdüsen mit Innendurchmessern von mehr als 1 mm, was eine besonders homogene und gleichmäßige Verteilung der Gasströmung ermöglicht.

Vorzugsweise ist die Vielzahl von Durchgangsbohrungen in einer Bohrungsdichte von mehr als 100 Düsen/100 cm² angeordnet.

Das erfindungsgemäße Gasverteilelement hat Gasdüsen mit definierter umlaufender Kante, definierter geätzter Oberfläche, angeordnet in hoher Gasdüsendichte. Alle diese Merkmale tragen zur Erzeugung einer vorgebbaren, definierten Gasströmung und einer reproduzierbaren Gasströmungsverteilung bei.

### Ausführungsbeispiel

Nachfolgend wird die Erfindung anhand eines Ausführungsbeispiels und einer Zeichnung näher erläutert. In der Zeichnung zeigt in schematischer Darstellung
- **Figur 1**: einen Ausschnitt einer Ausführungsform der erfindungsgemäßen rohrförmigen Gasverteilelementes in einer Seitenansicht,
- **Figur 2**: einen Ausschnitt einer weiteren Ausführungsform des erfindungsgemäßen Gasverteilelementes in einer Seitenansicht,
- **Figur 3**: die den Figuren 1 und 2 gezeigten Gasverteilelemente in einer Draufsicht,
- **Figur 4**: eine Vorrichtung zur chemischen Bedampfung und zum Ätzen von Einzel-Wafern in einer Querschnittsansicht, und
- **Figur 5**: eine weitere Ausführungsform eines anhand des erfindungsgemäßen Verfahrens hergestellten Gasverteilelements in Form einer Gasverteilerplatte zum Einsatz in der Vorrichtung von Figur 4 in einer Draufsicht.

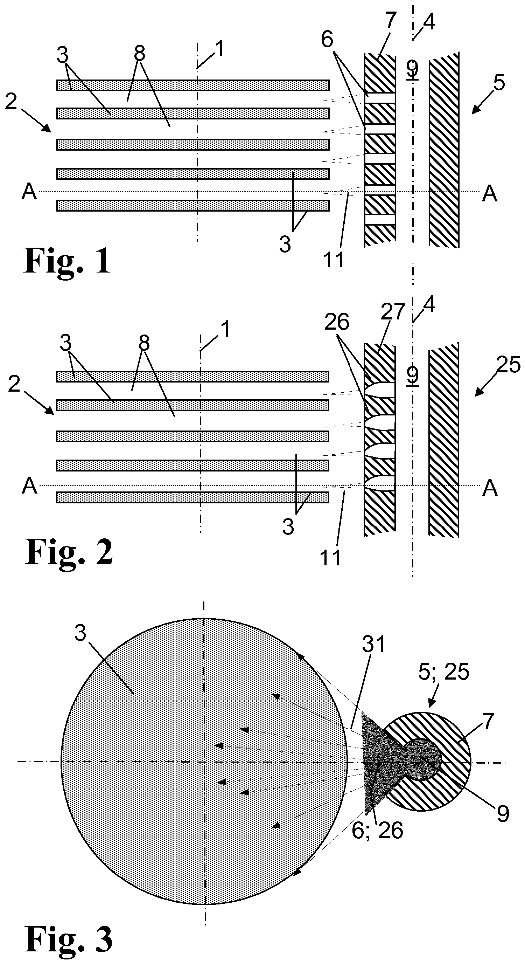

**Figur 1** zeigt schematisch einen um eine Rotationsachse 1 rotierbaren Waferstapel 2 mit mehreren parallel zueinander und äquidistant zueinander angeordneten Wafern 3. Entlang des Waferstapels 2 erstreckt sich ein Gasverteilelement in Form eines rohrförmigen Gasinjektors 5 mit vertikal orientierter Längsachse 4.

Der Gasinjektor 5 weist eine Vielzahl von Gasdüsen 6 auf, die sich an der dem Waferstapel 1 gegenüberliegenden Seite durch die Rohr-Wandung 7 erstrecken. Auch die Gasdüsen 6 haben äquidistanten Abstand, wobei jeweils eine Gasdüse 6 in der Höhe eines Zwischenraums 8 zwischen zwei benachbarten Wafern 3 angeordnet ist.

Die Innenbohrung 9 des rohrförmigen Gasinjektors 5 hat einen Durchmesser von 10 mm; die Wandstärke beträgt 2 mm.

Die Gasdüsen 6 dienen bei der Bearbeitung der Wafer-Oberfläche zur Zufuhr von Prozessgasen in den Wafer-Wafer-Zwischenraum 8. Da der Durchfluss der Gasdüsen 6 nicht individuell geregelt wird, sondern das Gas in die Innenbohrung 9 des Gasinjektors 5 geregelt eingebracht wird, teilt sich die Gasströmung entsprechend der relativen Strömungswiderstände der Gasdüsen 6 auf. Eine Homogenität beziehungsweise eine Gasverteilung entsprechend einem vorgegebenen Strömungsmuster erfordert daher eine hohe Präzision jeder einzelnen Gasdüse 6 des Gasdüsen-Arrays.

Im einfachsten Fall sind alle Gasdüsen 6 als Runddüsen mit gleichem Innendurchmesser von beispielsweise 2 mm ausgeführt. Bei der in Figur 1 gezeigten Ausführungsform ist die Gasdüse allerdings als Flachdüse mit rechteckiger Düsenöffnung ausgeführt. Die längere Seite der Düsenöffnung verläuft dabei parallel zur Wafer-Oberfläche und die kürzere Seite senkrecht dazu. Die flache Ausführung der Düsenöffnung bewirkt, dass der Gasstrom horizontal möglichst homogen im Zwischenraum 8 verteilt wird, wie durch die punktierten Linien 11 angedeutet.

Eine weitere Optimierung der Gasströmungsverteilung wird erreicht, wenn sich die breite Öffnungsweite in Glasflussrichtung zusätzlich erweitert, wie dies **Figur 3** schematisch zeigt. Die so gestaltete Flachdüse dient als Gas-Diffusor, mit der Wirkung, dass sich die Ausströmungsgeschwindigkeit verlangsamt und eine fächerartige Verteilung des Behandlungsgases über der Wafer-Oberfläche erreicht wird, wie in Figur 3 durch die Richtungspfeile 31 angedeutet.

Bei einer alternativen Ausführungsform ist die Flachdüse als dichte Aneinanderreihung mehrere Reihen mit jeweils einer Vielzahl von Gasdüsen mit rundem Düsenquerschnitt und einem Düsendurchmesser von 0,5 mm ausgeführt. Diese Gasdüsen bilden eine Gasdüsendichte von mehr als 100 Gasdüsen pro 100 cm².

Zur Bezeichnung gleicher oder äquivalenter Bauteile wie in Figur 1 sind in den Figuren 2 und 3 dieselben Bezugsziffern verwendet und es gelten die obigen Erläuterungen dazu. Der gemäß **Figur 2** sich entlang des Waferstapels 2 erstreckende rohrförmige Gasinjektor 25 weist eine Vielzahl von Gasdüsen 26 auf, die sich an der dem Waferstapel 1 gegenüberliegenden Seite durch die Rohr-Wandung 27 erstrecken. Die Gasdüsen 26 haben äquidistanten Abstand, wobei jeweils eine Gasdüse 26 in der Höhe eines Zwischenraums 8 zwischen zwei benachbarten Wafern 3 angeordnet ist. Die Innenbohrung 9 des rohrförmigen Gasinjektors 25 hat einen Durchmesser von 10 mm; die Wandstärke beträgt 2 mm.

Die Gasdüsen 26 sind als Flachdüsen mit rechteckiger Düsenöffnung ausgeführt, wobei längere Seite der Düsenöffnung parallel zur Wafer-Oberfläche und die kürzere Seite senkrecht dazu verläuft. Außerdem erweitert sich die breite Öffnungsweite in Glasflussrichtung kontinuierlich, wie in **Figur 3** schematisch gezeigt. Wie auch oben zur Ausführungsform von Figur 1 erläutert, wirken die Gasdüsen 26 infolge dieser Geometrie der Innenkontur als Gas-Diffusoren, die den Gasstrom zum einen vertikal auf den Zwischenraum 8 konzentrieren und ihn zum anderen horizontal möglichst homogen fächerartig verteilen.

Die Gasdüsen 26 haben aber darüber hinaus eine Innenkontur, bei der sich die Öffnungsweite der Düsen 26 in Gasflussrichtung stetig verjüngt. Diese Verjüngung bewirkt eine Fokussierung des Gasstroms in vertikaler Richtung. Die nichtsymmetrische Innenkontur der Gasdüsen 26 ist mittels der mechanischen oder thermischen Abtragsmethoden aus dem Stand der Technik nicht herstellbar.

Das erfindungsgemäße Verfahren ermöglicht hingegen die Herstellung komplexer Freiform-Düsen, ohne dass dafür die Öffnung von beiden Seiten bearbeitet werden muss. Es sind nicht nur beliebige Querschnittsformen quer zur Gasflussrichtung realisierbar, wie die erwähnten schlitzförmigen, ovalen, oder rechteckigen Düsenformen, sondern auch komplexe Querschnittsformen in Gasflussrichtung, wie etwa bei einer Lavaldüse.

Auch Düsenarrays mit individuell veränderter Geometrie können hergestellt werden. Dies eröffnet die Möglichkeit, ein berechnetes Soll-Strömungsprofil durch kontinuierliche Veränderung der Düsenform abzubilden. Die Form- und Positionsdaten der individuellen Gasdüsen ergeben sich beispielsweise aus einer optimierten Strömungssimulation.

Im Folgenden wird das erfindungsgemäße Verfahren näher erläutert. Das Verfahren umfasst folgende Verfahrensschritte:
(I) Es wird ein Rohr aus transparentem und möglichst blasenfreiem Quarzglas mit einem Außendurchmesser von 14 mm und einem Innendurchmesser von 10 mm bereitgestellt. Das Quarzglas ist unter der Bezeichnung HSQ 300 von der Firma Heraeus Quarzglas GmbH & Co. KG im Handel. Es ist aus natürlich vorkommenden Rohstoffen in einem widerstandsbeheizten Ofen elektrisch erschmolzen und hat einen Hydroxylgruppengehalt von weniger als 30 Gew.-ppm. Die Rohr-Mantelflächen ist innen und außen sind vollkommen glatt, so dass keine Politur erforderlich ist.
(II) Zur Erzeugung der in den Figuren 1 bis 3 schematisch dargestellten und oben näher beschriebenen Gasdüsen (Flachdüsen) werden die Abmessungen des Quarzglasrohres optisch erfasst und die Daten in ein Programm zur dreidimensionalen Strukturierung von Oberflächen eingespeist. Auf Basis von Daten des Waferstapels, wie etwa des Wafer-Wafer-Abstandes und der Anzahl der Wafer, werden Soll-Positionen für die Gasdüsen festgelegt und an diese Positionen ein dreidimensionales fiktives Modell der Gasdüsen-Innenkontur in die Rohrwandung projiziert.
(III) Das so vermessene und für die dreidimensionale Strukturierung vorbereitete Quarzglasrohr wird in ein mehrachsiges Bewegungsaggregat einer Femtosekundenlaser-Bearbeitungsvorrichtung eingespannt und mittels Ultrakurzpulslaserbestrahlung mit folgenden Parametern behandelt:
   Numerischer Apertur der Fokussierlinse: 0,4 NA,
   Wellenlänge: 1030 nm,
   Pulsrate: 40 fs,
   Pulsenergie: 300 nJ.
   Dabei wird das Quarzglasrohr mittels des Bewegungsaggregats auf einer Bahn so geführt, dass der Fokus des Femtosekundenlasers die vorab definierte Innenkontur aller Gasdüsen nacheinander abrastert, so dass entlang der Innenkontur eine ca. 20 µm dicke Schicht aus vorgeschädigtem Quarzglas erzeugt wird. Diese Schicht umgibt jeweils einen Pfropfen aus nicht bestrahltem Quarzglas. Dieser Prozess wird für alle Gasdüsen nacheinander ausgeführt.
(IV) Das Quarzglasrohr wird in ein Ätzbad mit 35% KOH, eingebracht und 40 Stunden bei einer Temperatur von 80 °C mit Ultraschall behandelt. Die Ätzrate des vorgeschädigten Quarzglases ist um mindestens den Faktor 10 größer als die des nicht vorgeschädigten Quarzglases, so dass sich die Schicht aus vorgeschädigtem Quarzglas auflöst und die verbleibenden Pfropfen aus nicht bestrahltem Quarzglasaus den erzeugten Öffnungen der Rohrwandung herausfallen.
(V) Die Kontur der zu entfernenden Struktur wird zwar durch die Laserbestrahlung vorgegeben, die eigentliche Formung erfolgt aber beim Wegätzen des Materials. Dementsprechend zeigen sowohl die Innenwandung der Öffnungen als auch die Mantelflächen des Quarzglasrohres keine polierte, sondern eine raue Oberfläche mit Ätzstruktur. Diese raue Oberfläche kann durch Tempern bei Temperaturen oberhalb: 1200°C geglättet werden, wobei es aber insbesondere bei filigranen und komplexen Bauteilen zu Verformungen kommen kann. Auch das Laser- oder Flammenpolieren der Oberfläche ist bei kleinen Öffnungsdurchmessern (unter 1 mm) kaum noch möglich.

Das so erzeugte Gasverteilelement zeichnet sich durch hohe Präzision aus. Im Vergleich zu den bekannten Methoden werden durch das Erzeugen der Gasdüsen beim Laser-Ätz-Verfahren keine oder geringe Spannungen in das Werkstück eingebracht, welche auf Dauer zu Rissen führen können. Daher kann auf ein Tempern, das ebenfalls zu plastischen Verformungen oder zu Veränderung der fiktiven Temperatur führen kann, verzichtet werden.

Werden die Gasdüsen - wie bisher üblich - thermisch mittels CO₂-Laserbohren erzeugt, so wird die Bohrungskante so heiß, dass sie aufschmilzt und einen Wulst um den Bohrungsrand bildet. Der Wulst kann aber nur sehr aufwendig mechanisch entfernt werden; etwa durch Schleifen der Zylindermantelfläche, und führt zu einem bleibenden Qualitätsverlust.

Im Unterschied dazu entfällt beim Erzeugen der Öffnungen durch die Laser-Ätz-Methode die Notwendigkeit für eine nachträgliche Glättung, denn es sind keine wulstartigen Materialanhäufungen und Unebenheiten um den Rand der Öffnungen vorhanden. Die Öffnungen zeigen sowohl an der Rohr-Innenwandung als auch an der Rohr-Außenwandung eine definierte Kantenform. Die Kante wird dabei von Kantenflächen mit reproduzierbarer, gleichmäßiger Ätzstruktur gebildet, die die Gasströmung vergleichsweise wenig beeinflussen.

Das erfindungsgemäße Verfahren wird auch zur Herstellung plattenförmiger Gasinjektoren für die Single-Wafer-Prozessierung eingesetzt.

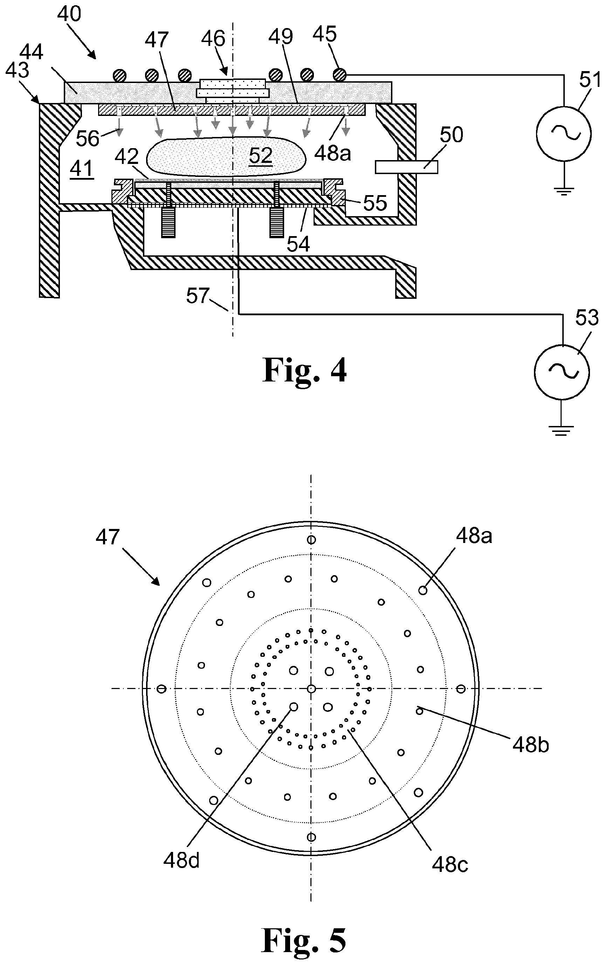

**Figur 4** zeigt schematisch einen typischen Plasmareaktor 40, wie er für Trockenätz- und Beschichtungsprozesse für Einzel-Wafer 42 eingesetzt wird. Der Reaktor 40 weist ein Gehäuse 43 auf, das eine Plasma-Reaktorkammer 41 umschließt. Der obere Abschluss des Gehäuses 43 wird von einem dielektrischen Fenster 44 gebildet, das im Wesentlichen als Rundplatte mit einem Durchmesser von 520 mm und einer Plattendicke von 40 mm ausgeführt ist. Aus seiner Oberseite liegt eine obere, spulenförmige Elektrode 45 auf.

Das dielektrische Fenster 44 hat eine Mittenbohrung zur Aufnahme eines Injektors 46, in den eine oder mehrere Gaszufuhrleitungen für Prozessgase münden.

Über den Injektor wird Prozessgas in einen gasdicht abgeschlossenen Gasverteilerraum 49 eingespeist. Dieser wird gebildet von dem dielektrischen Fenster 44 und einer an dessen Unterseite montierten Gasverteilerplatte 47 (showerhead) aus Quarzglas. Die Oberseite der Gasverteilerplatte 47 hat einen umlaufenden erhöhten Rand, der am dielektrischen Fenster dicht anliegt und den Gasverteilerraum 49 abschließt.

Die Gasverteilerplatte 47 befindet sich oberhalb des zu behandelnden Wafers 42 innerhalb der Plasmareaktorkammer 41, und sie ist mit einer Vielzahl von Gasdüsen 48a, 48b, 48c und 48d (siehe Figur 5) versehen, die sich als Durchgangsbohrungen zwischen dem Gasverteilerraum 49 und der Unterseite der Gasverteilerplatte 47 erstrecken. Die Gasdüsen 48a, 48b, 48c und 48d sind gruppenweise auf konzentrischen Kreisen um die Mittelachse 57 angeordnet, wobei sich die Gasdüsen-Gruppen voneinander in ihrer Größe, Form und/oder Orientierung unterscheiden. Sie sind geeignet, Gasströmungen unterschiedlicher Stärke und Richtung zu erzeugen, wie von den Richtungspfeilen 56 angedeutet.

Die Gasdüsen 48c haben beispielsweise einen Innendurchmesser von 0,8 mm und sie bilden eine Gasdüsendichte von mehr als 100 Gasdüsen pro 100 cm².

Bei den auf einem äußeren Kreisring angeordneten Gasdüsen 48b schließt deren Mittelachse mit der Normalen auf die Unterseite der Gasverteilerplatte 47 einen Neigungswinkel von 30 Grad an, so dass die Gasdüsen 48a eine nach innen in Richtung der Platten-Mittelachse 57 gerichtete Gasströmung bewirken. Die Gasverteilerplatte 47 und deren Herstellung werden anhand Figur 5 noch näher erläutert.

Um einen für eine Plasmabearbeitung geeigneten niedrigen Druck zu schaffen, ist die Reaktorkammer 41 über einen Gasauslass 50, der mit einer (nicht dargestellten) Hochvakuumpumpe verbunden ist, evakuierbar. Durch Anregung der oberen Elektrode 45 mittels einer Hochfrequenz-Energiequelle 51 (13,56 MHz) kann Energie in ein innerhalb der Reaktorkammer 41 gezündetes Plasma 52 kapazitiv eingekoppelt werden. Eine weitere HF-Energiequelle 53 ist mit einer unteren Elektrode 54 verbunden, die unterhalb des zu bearbeitenden Wafers 42 positioniert ist. Der Wafer 42 ist dabei auf einer Halteeinrichtung fixiert und zur Homogenisierung der Plasma-Einwirkung von einem Ätzring 55 umgeben.

Die Draufsicht auf die Unterseite der Gasverteilerplatte 47 in **Figur 5** zeigt die Kreisform der Quarzglasplatte. Sie ist flach, abgesehen von einer Einbuchtung auf der Oberseite, die den Gasverteilerraum 49 (Figur 4) bildet. Ihr Durchmesser beträgt 450 mm und die Plattenstärke 7 mm. Entlang konzentrischer Kreise sind die Gasdüsen 48a, 48b, 48c, 48d angeordnet sind. Die auf ein und demselben Kreisring angeordneten Gasdüsen sind jeweils gleich; sie unterscheiden sich in Größe, Form oder Orientierung aber von den Gasdüsen auf einem anderen Kreisring. Dadurch kann reproduzierbar eine definiert nicht- homogene Gasverteilung über der Wafer-Oberfläche eingestellt werden, die beispielsweise eine nichthomogene Temperaturverteilung berücksichtigt und kompensiert, so dass letztlich eine gleichmäßige Bedampfung oder Abtragung erreicht werden kann.

Das Erzeugen der Gasdüsen 48a, 48b, 48c, 48d in der Gasverteilerplatte 47 erfolgt analog dem für rohrförmige Gasinjektoren beispielhaft erläuterten Verfahrensschritte (I) bis (V) und wird im Folgenden näher erläutert. Das Verfahren umfasst folgende Verfahrensschritte:
(I) Es wird eine Platte aus transparentem und möglichst blasenfreiem Quarzglas mit einem Außendurchmesser von 520 mm und einer Plattendicke von - 7 mm bereitgestellt. Das Quarzglas ist unter der Bezeichnung HSQ 300 von der Firma Heraeus Quarzglas GmbH & Co. KG im Handel. Es ist aus natürlich vorkommenden Rohstoffen in einem widerstandsbeheizten Ofen elektrisch erschmolzen und hat einen Hydroxylgruppengehalt von weniger als 30 Gew.-ppm. Beide Planseiten der Quarzglasplatte sind poliert.
(II) Zur Erzeugung der Öffnungen für die in den Figuren 4 und 5 schematisch dargestellten Gasdüsen 48a, 48b, 48c, 48d werden die Abmessungen der Quarzglasplatte optisch erfasst und die Daten in ein Programm zur dreidimensionalen Strukturierung von Oberflächen eingespeist. Auf Basis von Daten des zu prozessierenden Wafers werden Soll-Positionen für die , Gasdüsen festgelegt und an diese Positionen ein dreidimensionales fiktives Modell der Gasdüsen-Innenkontur in die Quarzglasplatte projiziert.
(III) Die so vermessene und für die dreidimensionale Strukturierung vorbereitete Quarzglasplatte wird in ein mehrachsiges Bewegungsaggregat einer Femtosekundenlaser-Bearbeitungsvorrichtung eingespannt und mittels Ultrakurzpulslaserbestrahlung mit folgenden Parametern behandelt:
   Numerischer Apertur der Fokussierlinse: 0,4 NA,
   Wellenlänge: 1030 nm,
   Pulsrate: 40 fs,
   Pulsenergie: 300 nJ.
   Dabei wird die Quarzglasplatte mittels des Bewegungsaggregats auf einer Bahn so geführt, dass der Fokus des Femtosekundenlasers die vorab definierte Innenkontur aller Gasdüsen nacheinander abrastert, wobei entlang der Innenkontur eine ca. 20 µm dicke Schicht aus vorgeschädigtem Quarzglas erzeugt wird. Diese Schicht umgibt jeweils einen Pfropfen aus nicht bestrahltem Quarzglas. Dieser Prozess wird für alle Gasdüsen nacheinander ausgeführt.
(IV) Die Quarzglasplatte wird in ein Ätzbad mit 35%iger KOH eingebracht und 40 Stunden lang bei einer Temperatur von 80 °C mit Ultraschall behandelt. Die Ätzrate des vorgeschädigten Quarzglases ist um mindestens den Faktor 10 größer als die des nicht vorgeschädigten Quarzglases, so dass sich die Schicht aus vorgeschädigtem Quarzglas auflöst und die verbleibenden Pfropfen aus nicht bestrahltem Quarzglasaus den erzeugten Perforationen Platte herausfallen.
(V) Die Kontur der zu entfernenden Struktur wird zwar durch die Laserbestrahlung vorgegeben, die eigentliche Formung erfolgt aber beim Wegätzen des Materials. Dementsprechend zeigt die Innenwandung keine polierte, sondern eine raue Oberfläche mit Ätzstruktur, deren mittlere Oberflächenrauigkeit durch einen Rₐ-Wert um 0,5 µm gekennzeichnet ist.
   Zur Glättung der Oberfläche wird in der Öffnung ein Lichtbogen gezündet, indem an Elektroden, die sich beiderseits an der Öffnung gegenüberliegen Hochspannung angelegt wird. Die Elektroden verfügen über Spitzen, die so nahe an der Öffnung positioniert werden, dass eine Beschädigung der empfindlichen Kanten der Düsenöffnung vermieden wird. Der gezündete Lichtbogen positioniert sich selbst innerhalb des Kanals, strahlt konzentrisch ab und poliert die Oberfläche, ohne dass eine signifikante Verformung eintritt.

Die so erzeugte Gasverteilerplatte 47 zeichnet sich durch hohe Präzision aus. Im Vergleich zu den bekannten Methoden werden durch das Erzeugen der Gasdüsen beim Laser-Ätz-Verfahren keine oder geringe Spannungen in das Werkstück eingebracht, welche auf Dauer zu Rissen führen können. Daher kann auf ein Tempern, das ebenfalls zu plastischen Verformungen oder zu Veränderung der fiktiven Temperatur führen kann, verzichtet werden.

Werden die Gasdüsen thermisch mittels CO₂-Laserbohren erzeugt, so wird die Bohrungskante so heiß, dass sie aufschmilzt und einen Wulst über die Plattenoberfläche bildet. Um nach dem Lochbohren wieder eine plane Oberfläche zu erhalten, müssen die Oberflächen der Quarzglasplatte nachträglich begradigt oder eingeebnet werden, beispielsweise durch Schleifen und Polieren. Hierbei können Schleif- und Polier-Rückstände in die Bohrungen gelangen. Im Unterschied dazu genügt beim erfindungsgemäßen Verfahren eine einfache Vorab-Politur der Quarzglasplatte. Denn beim Erzeugen der Öffnungen durch die Laser-Ätz-Methode entfällt die Notwendigkeit für ein nachträgliches Schleifen oder für eine Politur.

## Patentansprüche

1. Verfahren zur Herstellung eines eine Vielzahl von Gasdüsen aufweisenden Gasverteilelements für den Einsatz in der Halbleiterfertigung, durch Bereitstellen eines Basiskörpers aus Quarzglas mit mindestens einer Wandung, Definieren einer Soll-Position und einer Soll-Innenkontur für jede der Gasdüsen, und Erzeugen einer durchgehenden Öffnung in der Wandung an der Soll-Position und mit der Soll-Geometrie der jeweiligen Gasdüse, **dadurch gekennzeichnet, dass** das Erzeugen der Öffnung folgende Verfahrensschritte umfasst:
(a) Verändern mindestens eines Teils des Quarzglases im Bereich der zu erzeugenden Öffnung durch Bestrahlung mit ultrakurzen Laserpulsen im Femtosekundenbereich,
(b) Entfernen des veränderten Quarzglases durch Ätzen mittels Säure oder Lauge unter Bildung der Öffnung.

2. Verfahren nach Anspruch 1, **dadurch gekennzeichnet, dass** die zu erzeugende Öffnung eine umlaufende Innenwandung aufweist, und dass eine an die Innenwandung angrenzende Schicht des Quarzglases verändert wird, die einen nicht veränderten Kernbereich umgibt.

3. Verfahren nach Anspruch 1 oder 2, **dadurch gekennzeichnet, dass** die Innenkontur der Gasdüse mit einer sich in einer Gasflussrichtung erweiternden oder einer sich in der Gasflussrichtung verengenden Öffnungsweite definiert und erzeugt wird.

4. Verfahren nach Anspruch 3, **dadurch gekennzeichnet, dass** mindestens für einen Teil der Gasdüsen die Innenkontur als Innenkonus definiert und erzeugt wird.

5. Verfahren nach einem der Ansprüche 1 bis 3, **dadurch gekennzeichnet, dass** für mindestens für einen Teil der Gasdüsen eine schlitzförmige Innenkontur definiert und erzeugt wird.

6. Verfahren nach Anspruch 5, **dadurch gekennzeichnet, dass** eine schlitzförmige Innenkontur erzeugt wird, die eine schmale Öffnungsseite und eine breite Öffnungsseite hat, und dass sich die breite Öffnungsweite in Glasflussrichtung erweitert und dass sich die schmale Öffnungsweite in Glasflussrichtung verjüngt.

7. Verfahren nach einem der vorhergehenden Ansprüche, **dadurch gekennzeichnet, dass** die Wandung an der Soll-Position eine Oberfläche mit einer Flächennormalen aufweist, und dass eine durchgehende Bohrung mit einer Mittelachse erzeugt wird, die zur Flächennormalen geneigt ist.

8. Verfahren nach einem der vorhergehenden Ansprüche, **dadurch gekennzeichnet, dass** für eine erste Gruppe von Gasdüsen eine erste Innenkontur, und für eine zweite Gruppe von Gasdüsen eine zweite Innenkontur definiert wird, wobei sich die erste Innenkontur von der zweiten Innenkontur unterscheidet.

9. Verfahren nach einem der vorhergehenden Ansprüche, **dadurch gekennzeichnet, dass** ein Basiskörper eingesetzt wird, der aus Quarzglas besteht, das einen Hydroxylgruppengehalt im Bereich von 10 bis 300 Gew.-ppm aufweist.

10. Verfahren nach einem der vorhergehenden Ansprüche, **dadurch gekennzeichnet, dass** die Innenwandung der Öffnung auf eine Temperatur oberhalb von 1200 °C erhitzt und dadurch mindestens teilweise lokal aufgeschmolzen wird.

11. Verfahren nach Anspruch 10, **dadurch gekennzeichnet, dass** zum lokalen Aufschmelzen der Innenwandung ein Lichtbogen in der Öffnung gezündet wird.

12. Verfahren nach einem der vorhergehenden Ansprüche, **dadurch gekennzeichnet, dass** das Gasverteilelement nach dem Verfahrensschritt des Entfernens des veränderten Quarzglases ohne nachfolgende mechanische Glättung der Wandung erhalten wird.

13. Verfahren nach einem der vorhergehenden Ansprüche, **dadurch gekennzeichnet, dass** ein plattenförmiger Basiskörper mit einer Wandung mit planer, polierter Oberseite und planer, polierter Unterseite bereitgestellt wird, und dass das Gasverteilelement nach dem Verfahrensschritt des Entfernens des veränderten Quarzglases ohne nachfolgende mechanische Glättung der Oberseite und der Unterseite erhalten wird.

14. Gasverteilelement für den Einsatz in der Halbleiterfertigung, das einen Basiskörper mit einer beidseitig von Wandungsoberflächen begrenzten Wandung aufweist, durch die sich eine Vielzahl von Durchgangsbohrungen erstreckt, die jeweils mit den Wandungsoberflächen umlaufende Bohrungsränder bilden, **dadurch gekennzeichnet, dass** die Durchgangsbohrungen einen Innendurchmesser von weniger als 1 mm und die Bohrungsränder Kantenform haben und von Kantenflächen mit Ätzstruktur gebildet werden.

15. Gasverteilelement nach Anspruch 14, **dadurch gekennzeichnet, dass** die Vielzahl von Durchgangsbohrungen in einer Bohrungsdichte von mehr als 100 Düsen/100 cm² angeordnet sind.
